(19) **Europäisches Patentamt**

**European Patent Office**

**Office européen des brevets**

(11) **EP 1 178 526 A2**

(12) **EUROPEAN PATENT APPLICATION**

(43) Date of publication:
06.02.2002 Bulletin 2002/06

(51) Int Cl.[7]: **H01L 21/306**, C23F 1/24, C23F 1/46

(21) Application number: 01117723.5

(22) Date of filing: 27.07.2001

| | |
|---|---|
| (84) Designated Contracting States:<br>**AT BE CH CY DE DK ES FI FR GB GR IE IT LI LU MC NL PT SE TR**<br>Designated Extension States:<br>**AL LT LV MK RO SI**<br><br>(30) Priority: **31.07.2000 JP 2000231018**<br><br>(71) Applicants:<br>• **Mitsubishi Chemical Corporation Chiyoda-ku, Tokyo (JP)** | • **Nippon Kasei Chemical Company Limited Fukushima-ken (JP)**<br><br>(72) Inventors:<br>• **Haga, Sadao, Mitsubishi Chemical Corporation Kitakyushu-shi, Fukuoka-ken 806-0004 (JP)**<br>• **Itou, Katsuji Onahama, Iwaki-shi Fukushima-ken (JP)**<br><br>(74) Representative: **HOFFMANN - EITLE Patent- und Rechtsanwälte Arabellastrasse 4 81925 München (DE)** |

(54) **Mixed acid solution in etching process, process for producing the same, etching process using the same and process for producing semiconductor device**

(57)    There is disclosed an etching solution containing at least hydrofluoric acid, nitric acid and hexafluorosilicic acid wherein the concentration of hexafluorosilicic acid is not less than 10% by weight based on the weight of the etching solution.

**Description**

BACKGROUND OF THE INVENTION

The present invention relates to an etching solution (etchant), a process for producing the etching solution, an etching process using the etching solution, and a process for producing a semiconductor device. More particularly, the prevent invention relates to an etching solution capable of readily controlling an etching speed, inhibiting abrupt increase (i.e., so-called runaway) of the etching speed so as to provide a stable etching process, and allowing the waste etching solution to be readily reused; a process for producing the etching solution; an etching process using the etching solution; and a process for producing a semiconductor device.

As semiconductor devices used in electronic apparatuses such as computers, there are known semiconductor integrated circuits such as controlling elements and memory elements, or optical semiconductors. In the production of these semiconductor devices, a substrate (wafer) made of silicon, GaAs, GaP or InP is etched or laminated with a metal thin film to form electronic circuits thereon.

In particular, semiconductor devices using a silicon wafer are important since a large number of such devices have been extensively used in industrial applications. In the production of such semiconductor devices, the wafer is subjected to a plurality of surface treatments prior to forming integrated circuits thereon. Among these surface treatments, an etching process is especially important to determine conditions of the silicon substrate.

Hitherto, there have been known etching processes using as an etching solution, an acid solution containing nitric acid, hydrofluoric acid, sulfuric acid, phosphoric acid, acetic acid, etc., or a mixed acid solution containing a plurality of strong acids; etching processes using the above etching solution in combination with a solution containing alkaline chemicals such as NaOH and KOH; etching processes using an etching solution containing a buffer component in addition to the above etching solutions; or the like.

For example, the etching solutions composed of the mixed acid solution have been described in Japanese Patent Application Laid-Open Nos. 6-314684(1994), 6-45314(1994), 9-232279(1997) and 9-266194(1997), or the like. The etching solutions containing the alkaline chemical solution have been described in Japanese Patent Application Laid-Open No. 9-266193(1997) or the like. Also, the etching solutions using the mixed acid solution in combination with the alkaline chemical solution have been described in Japanese Patent Application Laid-Open No. 11-233485 (1999) or the like.

The process for the production of a silicon wafer generally includes sequential steps of picking-up a silicon crystal ingot, and slicing, lapping, etching and polishing the silicon crystal ingot. The wafer after lapping has been required to show a flatness with highest accuracy. For this reason, the surface portion of the wafer corresponding to a thickness of 40 to 60 $\mu$m must be removed by etching or the like in order to remove residual abrasive grains or process-affected layer therefrom. However, it is difficult to maintain a shape accuracy of the wafer after the lapping.

As etching solutions for the silicon wafer, there have been usually used three-component mixed acid solutions containing hydrofluoric acid, nitric acid and acetic acid, or containing hydrofluoric acid, nitric acid and phosphoric acid, as well as four-component mixed acid solutions further containing sulfuric acid in addition to the above three components.

Also, in Japanese Patent Application Laid-Open No. 10-50682(1998), there has been proposed an etching solution for silicon wafer, which is prepared by adding hydrogen fluoride to phosphoric acid. In addition, in Japanese Patent Application Laid-Open No. 11-194120(1999), there has been described an etching solution containing nitric acid, hydrofluoric acid and hexafluorosilicic acid. Further, in Japanese Patent Application Laid-Open No. 11-60377 (1999), there has been proposed an acid solution containing hexafluorosilicic acid and hydrofluoric acid, hydrogen peroxide, ammonium or ammonium fluoride, which is used as a treating solution for terminating the surface of silicon crystal with hydroxyl groups.

Recently, semiconductor devices have been required to have an extremely high shape accuracy with the increase in integration degree thereof. For this reason, many wafer makers tend to use a combined etching process including both alkali etching and acid etching.

In such a combined etching process, since an etching amount by the alkali etching is as large as 10 to 30 $\mu$m, an etching amount by the acid etching must be limited to an extremely small value of from about 5 to about 20 $\mu$m. For example, in the case where such an extremely thin etching is performed using the above-described three-component etching solution containing hydrofluoric acid, nitric acid and acetic acid, it is required to considerably shorten the contact time between the etching solution and the wafer (time required for completing the etching) up to 5 to 20 seconds.

However, such a short-time etching operation cannot be achieved from viewpoint of the operating speed of etching process machines. Specifically, the etching process machines still have mechanical problems upon picking-up of wafer or the like.

To solve the above problems, there have been proposed a method of controlling the etching speed by increasing the concentration of acetic acid or phosphoric acid in the mixed acid solution. Actually, it is known that acetic acid and phosphoric acid have no direct influence on the etching reaction of silicon, and act as an inhibitor for reducing the etching speed.

However, when the concentration of acetic acid contained in the three-component etching solution composed of hydrofluoric acid, nitric acid and acetic acid is increased to reduce the etching speed, the etching reaction becomes nonuniform as described in Japanese Patent Application Laid-Open No. 6-314684(1994), so that the silicon wafer tends to be etched unevenly. It is suggested that the oxidation reaction of silicon by nitric acid is inhibited by the increase in concentration of acetic acid. More specifically, it is considered that the surface of the silicon wafer is inhibited from being uniformly oxidized since uneven distribution of concentration of the oxidizing agent is caused in the etching solution.

The uneven etching results in poor maintenance and control of wafer quality. Therefore, it is difficult to use the etching solution containing acetic acid at an increased concentration.

Also, when the concentration of phosphoric acid contained in the three-component etching solution composed of hydrofluoric acid, nitric acid and phosphoric acid is increased, it is possible to reduce the etching speed only at an initial stage of the etching process using a virgin etching solution. However, subsequent repeated etching operations tend to cause abnormal increase of the etching speed for the below-mentioned reasons, resulting in runaway of the etching reaction. Meanwhile, the "runaway of etching reaction" means such a condition that the etching reaction rate is suddenly instantaneously accelerated during the Si etching step, and the etching reaction becomes uncontrollable.

When hydrofluoric acid and phosphoric acid are mixed together, fluorophosphoric acid is produced. The fluorophosphoric acid has no direct influence on the silicon etching, but is hydrolyzed by water produced upon the silicon etching and dissociated into hydrofluoric acid and phosphoric acid which both increase the etching speed. Therefore, it is considered that the concentrations of hydrofluoric acid and phosphoric acid are increased with the progress of the etching reaction, so that the etching speed becomes extraordinarily high, thereby causing the runaway of the etching reaction. According to knowledge of the present inventors, when the silicon wafer is etched with the mixed acid solution composed of hydrofluoric acid, nitric acid and phosphoric acid at an etching speed of usually not less than 12 $\mu$m/minute (0.2 $\mu$m/sec.), the runaway reaction is caused during the etching.

As seen from the above, the three-component etching solutions composed of hydrofluoric acid, nitric acid and acetic acid (or phosphoric acid) have problems such as deteriorated etching performance and unstable etching process in addition to the above poor controllability of the etching speed in the etching process. Further, the etching solutions containing acetic acid and phosphoric acid have additional problems such as attendant of irritative order upon treatment of the waste etching solution. In addition, since the waste etching solution has now been discarded without any reclaiming treatment, significant problems have been caused in current industrial fields where recycling of products are strongly required.

On the other hand, as described above, conventionally known etching solutions composed of the mixed acid solution containing a silicon compound such as hexafluorosilicic acid still fail to show a sufficient etching performance.

SUMMARY OF THE INVENTION

It is an object of the present invention to provide an etching solution capable of providing a semiconductor wafer, especially a silicon wafer which shows an improved flatness and gloss required therefor and is free from the formation of waviness over the whole body thereof, readily selects an optimum etching speed, maintains the stable etching rate, and is readily reused in extensive application fields; a process for producing the etching solution; and a method of effectively using the etching solution.

As a result of the present inventors' earnest studies for solving the above problems, it has been found that:

(1) since the fluorosilicic acid acts as an inhibitor for etching reaction, a nitric acid/hydrofluoric acid-based etching solution containing hexafluorosilicic acid at not less than a predetermined concentration can readily control the etching speed and exhibit an excellent performance without runaway of the etching reaction; and

(2) when a silicon wafer is etched with an etching solution containing hydrofluoric acid and nitric acid, silica dissolved in the etching solution by the etching reaction is chemically reacted with the mixed acid solution according to the following reaction formula (1):

$$3Si + 4HNO_3 + 18HF \rightarrow 3H_2SiF_6 + 4NO + 8H_2O \qquad (1)$$

Upon etching the silicon wafer, hydrofluoric acid and nitric acid are consumed to produce hexafluorosilicic acid, water and nitrogen monoxide as reaction products. Therefore, the waste etching solution can be reused by removing the hexafluorosilicic acid produced by the etching and replenishing hydrofluoric acid and nitric acid consumed by the etching.

Also, the etching solution containing hydrofluoric acid, nitric acid and hexafluorosilicic acid is produced according to the above reaction formula. Specifically, the etching solution is produced by reacting hydrofluoric acid, nitric acid and a silicon compound with each other. In particular, when fuming nitric acid is used as the nitric acid source, or when a hydrogen fluoride gas is used as the hydrofluoric acid source, it is possible to readily produce a mixed acid solution containing nitric acid, hydrofluoric acid and hexafluorosilicic acid at high concentrations. This production method of the mixed acid solution is not only simple and safe, but also advantageous since the concentrations of the respective components may be optionally selected.

The present invention has been attained on the basis of the above findings.

To accomplish the aims, in a first aspect of the present invention, there is provided an etching solution containing at least hydrofluoric acid, nitric acid and hexafluorosilicic acid, the concentration of said hexafluorosilicic acid being not less than 10% by weight based on the weight of the etching solution.

In a second aspect of the present invention, there is provided a process for producing an etching solution containing hydrofluoric acid, nitric acid and hexafluorosilicic acid by reacting hydrofluoric acid, nitric acid and a silicon compound with each other, which comprises using a hydrogen fluoride gas as the hydrofluoric acid or fuming nitric acid as the nitric acid to react with the silicon compound.

In a third aspect of the present invention, there is provided a process for etching a silicon substrate, which comprises subjecting a silicon substrate to etching treatment using an etching solution containing at least hydrofluoric acid, nitric acid and hexafluorosilicic acid; after the etching treatment, subjecting the etching solution to quantitative analysis to determine a composition thereof; controlling the concentration of the etching solution after the etching treatment on the basis of the results of the quantitative analysis such that the concentrations of hydrofluoric acid, nitric acid and hexafluorosilicic acid are adjusted to 1 to 20% by weight based on the weight of the etching solution, 20 to 60% by weight based on the weight of the etching solution and not less than 10% by weight based on the weight of the etching solution, respectively; and etching the silicon substrate using the resultant solution as an etching solution.

BRIEF DESCRIPTION OF THE DRAWING

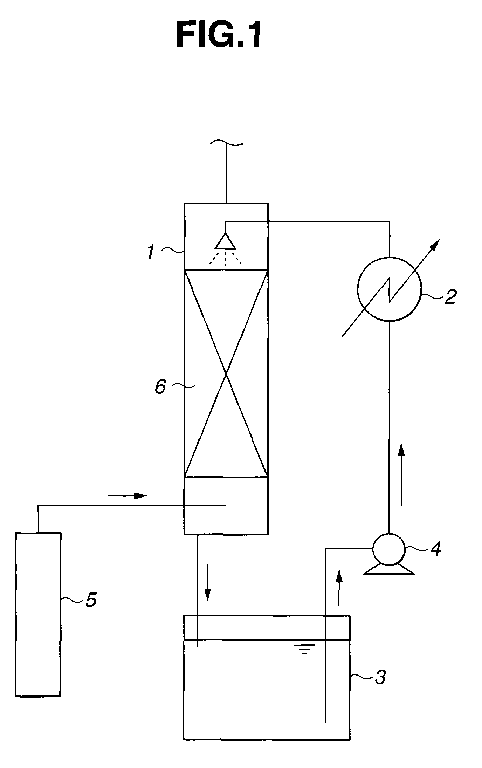

Fig. 1 is an explanatory view showing an example of a production facility usable for producing the mixed acid solution of the present invention.

DETAILED DESCRIPTION OF THE INVENTION

The present invention will be described in detail below.

(1) Etching solution:

The etching solution of the present invention is a solution containing at least hydrofluoric acid, nitric acid and hexafluorosilicic acid. The concentration of the hexafluorosilicic acid contained in the etching solution is not less than 10% by weight based on the weight of the etching solution, preferably not less than 14% by weight based on the weight of the etching solution, more preferably not less than 15% by weight based on the weight of the etching solution, still more preferably not less than 20% by weight based on the weight of the etching solution, most preferably not less than 22% by weight based on the weight of the etching solution. The upper limit of the concentration of the hexafluorosilicic acid is not particularly restricted. However, when the concentration of the hexafluorosilicic acid is too high, the etching speed is lowered so that the time required for picking-up the wafer tends to be undesirably prolonged. Therefore, the concentration of the hexafluorosilicic acid contained in the etching solution is preferably not more than 40% by weight based on the weight of the etching solution, more preferably not more than 30% by weight based on the weight of the etching solution, still more preferably not more than 27% by weight based on the weight of the etching solution.

When the concentration of the hexafluorosilicic acid is too low, the etching speed is so high that the etching solution tends to become unusable practically. In addition, in the etching solution where the concentration of the hexafluorosilicic acid is too low, the amount of water contained in the etching solution becomes large, so that a certain kind of wafer etched by such an etching solution tends to show a poor quality. On the other hand, when the concentration of the hexafluorosilicic acid is too high, the etching speed tends to become low, resulting in industrial disadvantageous process.

The concentrations of hydrofluoric acid and nitric acid contained in the etching solution may appropriately vary depending upon kind of wafer etched, etching method, required etching speed or the like.

The concentration of the hydrofluoric acid contained in the etching solution is usually not less than 1% by weight based on the weight of the etching solution, preferably not less than 2% by weight based on the weight of the etching solution, more preferably not less than 5% by weight based on the weight of the etching solution, and is usually not more than 20% by weight based on the weight of the etching solution, preferably not more than 15% by weight based on the weight of the etching solution.

The concentration of the nitric acid contained in the etching solution is usually not less than 20% by weight based on the weight of the etching solution, preferably not less than 25% by weight based on the weight of the etching solution, more preferably not less than 30% by weight based on the weight of the etching solution, and is usually not more than 60% by weight based on the weight of the etching solution, preferably not more than 40% by weight based on the weight of the etching solution.

In the present invention, the etching speed may be optionally controlled by varying the composition of the etching solution. The etching speed may be determined depending upon the etch amount. When the etch amount is about 20 to about 40 $\mu$m, the etching speed is usually not more than 20 $\mu$m/minute, preferably not more than 14.5 $\mu$m/minute. Especially, when the etching speed is less than 14.5 $\mu$m/minute, the etching solution shows an excellent stability. Although the lower limit of the etching speed is not particularly restricted, when the etching speed is too low, the etching time is undesirably prolonged. Therefore, the etching speed is usually not less than 10 $\mu$m/minute, preferably not less than 14 $\mu$m/minute.

When the etch amount is as small as about 0.5 to about 2 $\mu$m, for example, in the case of etching for ultrathin film, the etching speed is usually not less than 1 $\mu$m/minute, preferably not less than 2 $\mu$m/minute, and is usually not more than 5 $\mu$m/minute, preferably not more than 2 $\mu$m/minute.

The etching solution capable of exhibiting an etching speed of about 15 $\mu$m/minute (0.25 $\mu$m/sec.), for example, when etched by the below-mentioned method, has such a composition that the concentration of hydrofluoric acid is usually not less than 5% by weight based on the weight of the etching solution, preferably not less than 7.5% by weight based on the weight of the etching solution, and is usually not more than 10% by weight based on the weight of the etching solution, preferably not more than 9.5% by weight based on the weight of the etching solution. The concentration of nitric acid is usually not less than 30% by weight based on the weight of the etching solution, preferably not less than 35.5% by weight based on the weight of the etching solution, and is usually not more than 40% by weight based on the weight of the etching solution, preferably not more than 37.5% by weight based on the weight of the etching solution. The concentration of hexafluorosilicic acid is usually not less than 10% by weight based on the weight of the etching solution, preferably not less than 12.5% by weight based on the weight of the etching solution, and is usually not more than 15% by weight based on the weight of the etching solution, preferably not more than 14.5% by weight based on the weight of the etching solution.

<u>\<Etching method\></u>

The mixed acid solution maintained at room temperature is circulated through a polyethylene etching vessel.

One silicon wafer having a diameter of 125 mm which has been subjected to lapping treatment, is slowly immersed in the mixed acid solution in the etching vessel, and picked-up therefrom usually after the elapse of 30 seconds to 3 minutes.

The picked-up silicon wafer is then washed with water to complete the etching process.

<u>\<Method of determining the etching speed\></u>

The etch amount is expressed by the weight difference of the silicon wafer between before and after the etching. The etching speed is calculated by dividing the etch amount by the time during which the silicon wafer is immersed in the mixed acid solution.

One feature of the present invention is that the etching solution contains hexafluorosilicic acid at a specific concentration.

Since the hexafluorosilicic acid is unreactive with nitric acid, hydrofluoric acid and silicon contained in the mixed acid solution, the etching speed can be readily controlled by varying the concentration of hexafluorosilicic acid contained in the etching solution. The hexafluorosilicic acid has no irritative odor unlike acetic acid.

The etching solution according to the present invention allows the etching rate, etc., to be readily controlled without adding acetic acid or phosphoric acid thereto. In the case where the etching solution does not contain acetic acid or phosphoric acid, there are caused no problems such as irritative odor and the like, so that the used etching solution as waste solution can be readily treated. Also, such a waste etching solution may be reused in other application fields, for example, as a cleaning solution for cleaning the surface of stainless steel.

The etching solution may usually contain water as one of essential components in addition to hydrofluoric acid, nitric acid and hexafluorosilicic acid. Further, the etching solution may contain other acid components such as acetic acid and phosphoric acid, or additives.

As described above, the etching solution of the present invention may contain acetic acid and/or phosphoric acid unless the addition thereof adversely affects the effects of the present invention. The content of the acetic acid is usually not less than 0.01% by weight based on the weight of the etching solution, preferably not less than 0.1% by weight based on the weight of the etching solution, and is usually not more than 10% by weight based on the weight of the etching solution, preferably not more than 5% by weight based on the weight of the etching solution. The content of the phosphoric acid is usually not less than 0.01% by weight based on the weight of the etching solution, preferably not less than 0.1% by weight based on the weight of the etching solution, and is usually not more than 10% by weight based on the weight of the etching solution, preferably not more than 5% by weight based on the weight of the etching solution, more preferably not more than 3% by weight based on the weight of the etching solution.

Also, the etching solution of the present invention may further contain various additives unless the addition thereof adversely affects the effects of the present invention. As the additives, there may be exemplified surfactants, complexing agents or the like.

Examples of the surfactants may include those described in Japanese Patent Application Laid-Open (KOKAI) No. 7-183288(1995). Among these surfactants, amine-based compounds are preferred. When the etching solution contains the surfactant, it is expected to improve a wettability of the wafer and inhibit foaming phenomenon.

The etching solution of the present invention is a strong acid having a pH value of usually not more than 1. The pH value of the etching solution may be appropriately adjusted depending upon kind of wafer etched, etching process or the like.

The etching solution of the present invention may be especially suitably used for etching a silicon wafer. This is because when the silicon wafer is etched with the etching solution, hexafluorosilicic acid required for controlling the etching speed is produced, thereby maintaining the etching solution in a stable state without reduction in concentration of the hexafluorosilicic acid contained therein and, therefore, stabilizing the etching reaction.

(2) Process for the production of etching solution:

The etching solution of the present invention can be produced by reacting hydrofluoric acid, nitric acid and a silicon compound with each other.

Examples of the hydrofluoric acid may include a hydrogen fluoride gas, hydrofluoric acid or the like. Examples of the nitric acid may include an aqueous nitric acid solution, a concentrated nitric acid, fuming nitric acid or the like. Here, the "concentrated nitric acid" and the "fuming nitric acid" mean aqueous nitric acid solutions having concentrations of 70% by weight and 98% by weight, respectively. It is preferred that the amount of impurities contained in the hydrofluoric acid and the nitric acid is small. Specifically, the content of the impurities in the hydrofluoric acid and the nitric acid is usually not more than 10 ppb, preferably not more than 5 ppb. When a hydrogen fluoride gas is used as the hydrofluoric acid or when fuming nitric acid is used as the nitric acid, it is possible to obtain an etching solution having a high hydrofluoric acid concentration or a high nitric acid concentration, since these raw materials have a low water content. More preferably, the hydrogen fluoride gas and the fuming nitric acid are used in combination.

Examples of the silicon compound may include silicon, silicon oxide or the like. Among these silicon compounds, silicon is preferred. Also, It is preferred that the amount of impurities contained in the silicon compound is small. Specifically, the content of the impurities contained in the silicon compound is usually not more than 1 ppb, preferably not more than 0.1 ppb.

For example, one liter of an etching solution containing about 9.1% by weight of hydrofluoric acid based on the weight of the etching solution, about 36.7% by weight of nitric acid based on the weight of the etching solution and about 13.8% by weight of hexafluorosilicic acid based on the weight of the etching solution may be produced by mixing 201 g of a hydrogen fluoride gas, 662 g of 70wt% nitric acid and 106 g of water with each other, and then dissolving 31 g of silicon in the resultant mixed acid solution.

Fig. 1 is an explanatory view showing an example of a production facility usable for producing the mixed acid solution of the present invention.

An absorption tower (1) is made of a vinyl chloride resin and filled with a Raschig ring (6) made of a fluororesin the inside thereof. At the lower portion the absorption tower (1) is disposed a polyethylene preparation tank (3) which is connected with the absorption tower through a circulation conduit. In the course of the circulation conduit, there are disposed a cooler (2) equipped with a vinyl chloride shell and a fluororesin tube, and a circulating pump (4) made of a fluororesin. Further, a feed conduit extending from a hydrofluoric acid bomb (5) is introduced into a lower portion of the absorption tower (1). All of these conduits are made of a fluororesin. With the above arrangement of the production apparatus made of such materials, impurities can be prevented from being eluted therefrom.

The nitric acid having an initial concentration of 70% by weight which is received in the preparation tank (3), is fed through the circulating pump (4), and then introduced in the form of mist or droplets into the absorption tower (1) from the upper portion thereof. Before the introduction into the absorption tower, the temperature of the nitric acid may be controlled by the cooler (2). Then, the hydrogen fluoride gas filled in the hydrofluoric acid bomb (5) is introduced into the absorption tower (1) from the lower portion thereof. The thus introduced hydrogen fluoride gas and industrial nitric acid are suitably contacted with each other by the action of the Raschig ring (6).

Meanwhile, when the hydrogen fluoride gas is reacted with the fuming nitric acid or concentrated nitric acid having a concentration of not less than 70% by weight, violent heat generation is caused. Therefore, the amount of the anhydrous hydrofluoric acid introduced must be controlled such that the temperature rise is within the safe range.

In addition, the silicon compound may be fed from optional portions of the above circulation system, or may be reacted with the mixed acid solution outside of the circulation system. It is preferred that the silicon compound is added to the preparation tank (3) after the mixed acid solution contained in the tank reaches a predetermined composition, so as to react with the mixed acid solution therein. The mixed acid solution recovered in the tank (3) is discharged therefrom after reaching the desired composition.

The amount of the nitric acid fed to the absorption tower (1) is usually 500 to 1,000 liters/hour. The amount of the hydrogen fluoride gas blown (fed) into the absorption tower (1) is usually 0.3 to 0.5 liter/hour. The temperature of the nitric acid or the mixed acid solution of hydrofluoric acid and nitric acid received in the preparation tank (3) is preferably not more than 30°C. Since the anhydrous hydrofluoric acid is dissolved in water entrained on the concentrated nitric acid, the inside of the absorption tower (1) undergoes violent temperature rise. Therefore, the inside temperature of the absorption tower (1) is suitably controlled to usually 20 to 40°C, preferably 20 to 30°C irrespective of amounts of the reactants introduced or the like.

Alternatively, in the production process of the present invention, the mixed acid solution may be produced by first reacting the fuming nitric acid (98wt% nitric acid aqueous solution) with the hydrofluoric acid (50wt% aqueous solution) and then adding a desired amount of the silicon compound to the resultant mixed acid solution. Upon the reaction, since the fuming nitric acid and hydrofluoric acid both are liquid, the silicon compound may be added after mixing both acids together. Thus, according to the above production process of the present invention, the mixed acid solution can be produced by a relatively simple method.

The process for producing the mixed acid solution according to the present invention not only can readily vary the composition of the resultant mixed acid solution, but also can be performed with a high safety. Therefore, in the process of the present invention, the amounts or concentrations of the reactants used (hydrofluoric acid, nitric acid, silicon compound, etc.) can be extensively varied, and the mixed acid solution can be produced at a high yield for a short reaction time.

(3) Etching process:

The etching solution of the present invention may be used for etching silicon wafer, GaAs wafer, GaP wafer, InP wafer or the like, preferably for etching the silicon wafer.

As the etching method, there may be exemplified a dip method using an etching vessel, a spray method using a conveyor, a single wafer spin-etching method using a spin coater, or the like.

For example, when the wafer is immersed in the etching solution by the dip method, it is preferred that the etching solution is flowed in the predetermined direction so as to form a constant etching solution flow, thereby avoiding the formation of turbulence upon impingement against walls of the etching vessel. Also, upon immersion into the etching solution, it is preferred that the wafer is set on a carrier made of, for example, Teflon, and immersed in parallel with the etching solution flow direction while rotating. This operation can prevent the wafer from remaining unetched at its portions fitted to the carrier.

Also, in order to remove fine debris adhered to the wafer, the etching solution is bubbled, if required. The bubbling of the etching solution also has effects of diffusing the reaction heat generated on the surface of the wafer, and discharging excessive NOx produced by oxidation reaction of the wafer, thereby preventing the occurrence of equilibrium reaction. Therefore, the bubbling is useful for stabilizing the reaction and enhancing a flatness of the etched wafer. For the same reason, a vibration plate may be disposed at the bottom of the etching vessel in order to produce megasonic or the like for generating high-frequency vibration.

When the wafer is immersed in the etching solution, the rotation number of the wafer, the flow rate and flow velocity of the etching solution, the bubbler flow rate or the like may be appropriately selected according to required properties and flatness of the wafer. In general, the rotating number of the wafer is 10 to 50 rpm; the circulating flow rate of the etching solution is 50 to 100 liters/minute; and the bubbler flow rate is 20 to 80 liters/minute.

Also, the temperature of the mixed acid solution during the etching process is usually not less than 20°C, preferably not less than 25°C, and is usually not more than 35°C.

In general, after completion of the etching process, the silicon wafer is immediately washed with ultrapure water. The time between picking-up and washing of the wafer is preferably within 0.5 second. Also, it is preferred that the ultrapure water in a washing vessel is replaced with a new one about three times during the washing, and the replacement of the ultrapure water is rapidly performed. For this purpose, for example, the use of QDV (quick dump valve) or the like is preferred.

When the etching solution of the present invention is used, for example, in order to etch a silicon wafer, the nitric acid, and hydrofluoric acid are consumed by the oxidation reaction between silicon and nitric acid and the reaction for removal of oxide film, resulting in reduction in amounts of these acids contained in the etching solution. On the other hand, in these reactions, hexafluorosilicic acid and water are produced. Accordingly, as will also be understood from the above reaction formula (1), in the etching solution after completion of the etching, the concentration of hexafluorosilicic acid becomes higher than the initial one, and the concentrations of nitric acid and hydrofluoric acid become lower than the initial one.

In the etching solution of the present invention, when the material to be etched is silicon, no impurities are produced by the etching, so that the etching solution can be recycled and reused.

More specifically, the etching solution containing at least hydrofluoric acid, nitric acid and hexafluorosilicic acid is used to etch a silicon substrate, and then after the etching treatment, the etching solution is subjected to quantitative analysis to determine a composition of the etching solution. On the basis of the results of the quantitative analysis, the concentration of the etching solution is controlled to the range specified in the above "(1) etching solution", more specifically, such that the concentrations of hydrofluoric acid, nitric acid and hexafluorosilicic acid are 1 to 20% by weight based on the weight of the etching solution, 20 to 60% by weight based on the weight of the etching solution and not less than 10% by weight based on the weight of the etching solution, respectively. Then, the resultant solution can be reused as an etching solution for etching the silicon substrate.

Thus, in the etching solution obtained after the etching treatment, the concentrations of nitric acid and hydrofluoric acid are reduced by water produced by the reaction as compared to the initial one. Therefore, in order to reuse the etching solution obtained after the etching treatment, it is necessary to restore the concentrations of nitric acid and hydrofluoric acid in the etching solution to initial concentrations thereof. For this purpose, it is required to add high-concentration nitric acid and hydrofluoric acid or a mixed acid solution thereof to the used etching solution obtained after the etching treatment, whereby it becomes possible to reduce the high concentration of hexafluorosilicic acid contained in the used etching solution to initial concentration thereof.

However, only when the concentration of the used etching solution is adjusted by adding nitric acid and hydrofluoric acid thereto, the total amount of the etching solution is increased every concentration adjustment thereof. Therefore, it is preferred to take out at least a part of the used etching solution for the concentration adjustment.

In the case where the whole amount of the used etching solution is taken out, a part of water and hexafluorosilicic acid is removed from the etching solution taken-out, and then a silicon compound, hydrofluoric acid, nitric acid and the like are added to the obtained solution according to the requirement in order to adjust the composition thereof. The resultant solution may be used again as an etching solution.

In the case where a part of the used etching solution is taken out, water and hexafluorosilicic acid are removed from the etching solution taken-out to obtain a mixed solution containing nitric acid and hydrofluoric acid at high concentrations. The obtained mixed solution is added to the used etching solution obtained after the etching treatment in order to adjust the composition thereof.

When a part of the used etching solution is taken out, the amount (E) of the used etching solution to be taken out is calculated from the following formula:

$$A - \{(D - B) \times A\} = E$$

wherein A is a volume of the etching solution; B is a concentration of hexafluorosilicic acid contained in an etching solution; and D is a concentration of hexafluorosilicic acid contained in the used etching solution obtained after the etching treatment.

The weight of hexafluorosilicic acid produced by the etching is also determined by the chemical reaction formula (1) as described above.

Although the amount of the used etching solution to be taken out can be determined on the basis of the above calculation formula, it is preferable to take out about 2 to about 5% by weight of the used etching solution, since the composition of the etching solution can be stabilized.

Alternatively, in the case where a part of the used etching solution obtained after the etching treatment is taken out, hexafluorosilicic acid is removed from the used etching solution taken-out, thereby obtaining a mixed acid solution composed of nitric acid and hydrofluoric acid. Then, a silicon compound, a hydrogen fluoride gas and concentrated nitric acid are added to the obtained mixed acid solution, if required. The resultant solution is added to the used etching solution obtained after the etching treatment in order to adjust the composition thereof.

In order to remove hexafluorosilicic acid and/or water from the used etching solution obtained after the etching treatment, there may be used, for example, a method of heating the etching solution under reduced pressure to convert hexafluorosilicic acid into silicon tetrafluoride ($SiF_4$) and separate the silicon tetrafluoride together with water in the form of gases.

As described above, the etching solution of the present invention can be readily recycled and reused.

The quantitative analysis used for determining the composition of the etching solution may be optionally performed, for example, by the method described in Japanese Patent Application Laid-Open (KOKAI) No. 11-194120 (1999).

The mixed acid solution of the present invention is capable of exhibiting excellent effects when used especially for the production of semiconductor devices composed mainly of a silicon substrate or a silicon thin film, i.e., capable of accurately reproducing the etching process and producing electronic circuits having a microstructure in an accurate and industrially stable manner. For example, when producing semiconductor devices by growing a silicon oxide film on a silicon substrate and then subjecting the substrate to photolithography step, development step or the like to form electronic circuits thereon, the mixed acid solution according to the present invention can be used especially in the etching step, etc. for removing residual silicon oxide film on the underlying substrate or impurities such as metal adhered onto the wafer. Such an etching process using the mixed acid solution according to the present invention can exhibit an industrially excellent effect of achieving various etching speeds as required for respective applications.

Examples

The present invention will be described in more detail by reference to the following examples. However, the following examples are only illustrative and not intended to limit the scope of the present invention thereto.

In the following Examples and Comparative Examples, the same apparatus as shown in Fig. 1 was used for producing a mixed acid solution. In the apparatus, the absorption tower (1) had a diameter of 100 mm and a height of 1,000 mm; and the preparation tank (3) had a capacity of 20 liters. The composition analysis was conducted by the following method. That is, 4 ml of a mixed acid solution containing hydrofluoric acid, nitric acid and hexafluorosilicic acid as produced according to the present invention, was mixed with 100 ml of decarbonated water to prepare a titration sample solution. Two milliliters of the thus obtained titration sample solution was mixed with 70 ml of acetone, and a fluororesin-coated rotor was placed in the solution. Then, the resultant solution was titrated with a NaOH/ethanol (1/10 N) standard solution while passing a nitrogen gas therethrough using a non-aqueous neutralization titration apparatus (tradename: "GT-07" manufactured by Mitsubishi Chemical Corporation). The results of the titration were plotted to prepare a titration curve from which three inflection points corresponding to equivalent points of nitric acid, hexafluorosilicic acid, hydrofluoric acid, acetic acid and the like were obtained, thereby determining the concentrations of these acids.

Separately, 1.7 ml of the titration sample solution was mixed with 250 ml of water. The obtained solution was measured using a ultraviolet region absorptiometer (tradename: "u-2001" manufactured by Hitachi Limited) to determine its absorbance at a wavelength of 302.0 mm inherent to nitric acid, thereby obtaining the concentration of the nitric acid.

Examples 1 to 13 and Comparative Examples 1 and 2:

Etching solutions having compositions as shown in Table 1 were prepared.

More specifically, in Example 1, 6,930 g of 70wt% nitric acid and then 880 g of water were charged into the preparation tank (3), and circulated therethrough at a circulation rate of 700 liters/hour. In addition, 2,190 g of a hydrogen fluoride gas was fed from the hydrofluoric acid bomb (5) into the absorption tower (1), and the hydrogen fluoride gas was absorbed and mixed in the circulated solution for 8 hours to prepare a mixed acid solution. Then, 310 g of silicon was supplied into the preparation tank (3), thereby obtaining an etching solution of the present invention having a hexafluorosilicic acid concentration of 13% by weight based on the weight of the etching solution.

In Examples 2 to 13, the same procedure as defined in Example 1 was conducted except that the amounts of hexafluorosilicic acid, nitric acid and hydrofluoric acid used were appropriately varied on the basis of reverse calculation from the concentrations of respective acids contained in each etching solution as shown, thereby obtaining etching solutions of the present invention. Also, in Comparative Examples 1 and 2, etching solutions were prepared by the same method as described above.

Meanwhile, a remaining part (not shown) of each composition as shown in Table 1 was water.

Into a polyethylene etching vessel was charged 4.6 liters of each etching solution. A silicon wafer having a diameter of 125 mm which has been subjected to lapping treatment and set on a carrier, was slowly immersed in the etching solution filled in the etching vessel. After one minute, the carrier was picked up from the etching vessel, and immediately washed with ultrapure water. The weight of the silicon wafer was measured before and after the etching using an electronic balance manufactured by Mettler-Toledo GmbH. The weight difference of the silicon wafer between before and after the etching was calculated to determine an etch amount thereof.

The silicon wafer was kept standstill in the etching vessel. The carrier holding the silicon wafer was rotated or oscillated, and only bubbling and circulation of the etching solution were performed. The etching was conducted at room temperature, and the etching solution temperature at initiation of the etching was 25°C.

Table 1

| Examples and Comparative Examples | Composition of mixed acid solution (wt. %) | | | | |
|---|---|---|---|---|---|
| | Hydro-fluoric acid | Nitric acid | Acetic acid | Phos-phoric acid | Silicic acid |
| Example 1 | 11.7 | 38.4 | – | – | 13.0 |
| Example 2 | 8.7 | 35.2 | – | – | 13.3 |
| Example 3 | 9.1 | 36.7 | – | – | 13.8 |
| Example 4 | 9.3 | 37.8 | – | – | 14.3 |
| Example 5 | 9.6 | 36.4 | – | – | 15.7 |
| Example 6 | 7.6 | 35.9 | – | – | 19.6 |
| Example 7 | 6.4 | 33.4 | – | – | 19.9 |
| Example 8 | 3.7 | 32.2 | – | – | 24.9 |
| Example 9 | 1.8 | 22.3 | – | – | 34.8 |
| Example 10 | 1.7 | 26.1 | – | – | 31.9 |
| Example 11 | 9.4 | 37.8 | 1.1 | – | 14.3 |
| Example 12 | 9.3 | 37.8 | – | 1.0 | 14.3 |
| Example 13 | 9.0 | 36.4 | – | 4.0 | 13.8 |
| Comparative Example 1 | 8.5 | 36.8 | 20.1 | – | 5.4 |
| Comparative Example 2 | 5.7 | 28.6 | – | 30.2 | 3.2 |

(Note) wt.%: wt.% based on the weight of the etching solution

Table 1 (continued)

| Examples and Comparative Examples | Etching speed and stability | | |
|---|---|---|---|
| | Etching speed | | Stability |
| | g/min. | μm/min. | |
| Example 1 | 1.762 | 29.9 | ○ |
| Example 2 | 0.856 | 14.5 | ○ |
| Example 3 | 0.861 | 14.8 | ○ |
| Example 4 | 0.847 | 14.3 | ◎ |
| Example 5 | 0.728 | 12.3 | ◎ |
| Example 6 | 0.695 | 11.7 | ◎ |
| Example 7 | 0.643 | 10.9 | ◎ |
| Example 8 | 0.437 | 7.4 | ◇ |
| Example 9 | 0.102 | 1.8 | ◇ |
| Example 10 | 0.294 | 5.0 | ◇ |
| Example 11 | 0.790 | 13.4 | ◎ |
| Example 12 | 0.769 | 13.0 | ◎ |
| Example 13 | 0.639 | 10.8 | ○ |
| Comparative Example 1 | 0.748 | 12.7 | △ |
| Comparative Example 2 | 0.646 | 11.0 | △ |

Table 1 (continued)

| Examples and Comparative Examples | Reusability of waste solution | Occurrence of runaway |
|---|---|---|
| Example 1 | ◎ | None |
| Example 2 | ◎ | None |
| Example 3 | ◎ | None |
| Example 4 | ◎ | None |
| Example 5 | ◎ | None |
| Example 6 | ◎ | None |
| Example 7 | ◎ | None |
| Example 8 | ◯ | None |
| Example 9 | ◯ | None |
| Example 10 | ◯ | None |
| Example 11 | △ | None |
| Example 12 | ◎ | None |
| Example 13 | △ | None |
| Comparative Example 1 | ✕ | None |
| Comparative Example 2 | △ | Occurred |

In Table 1, the "silicic acid" represents hexafluorosilicic acid; and respective symbols used in "Etching stability" and "Reusability of waste solution" concerning the used mixed acid solution after etching (easiness for reuse as a metal-surface cleaning solution), have the following meanings:

<Etching stability>

The etching stability means a stability of etching speed from initiation to termination of the etching, and the "stable" state means that the etching speed was kept substantially constant from initiation to termination of the etching.

◎ : Stable;

○: Slightly unstable, but practically usable;

◊: Stable, but etching speed was low (applicable to etching of (ultra)thin film);

Δ: Slightly unstable, and etching speed tended to be too rapid according to kind of wafer etched; and

×: Unstable.

<Reusability of waste solution>

◎ : No irritative odor and no impurities contained in the etching solution;
○: No practical problem due to irritative odor, but addition of acid components might be required upon practical use;
Δ: Strong irritative odor, and some problems were caused upon practical use; and
×: Strong irritative odor, and practically unusable.

As will be apparent from Table 1, the mixed acid solution of the present invention exhibited excellent etching speed and stability, and the waste solution had a good reusability. Also, in the etching process using such a mixed acid solution exhibiting an optimum etching speed according to the present invention, a semiconductor substrate such as silicon was enhanced in gloss as an index of substrate properties, resulting in production of an excellent substrate. The mixed acid solutions obtained in Comparative Examples 1 and 2 were deteriorated in etching stability and reusability of waste solution.

As described above, the mixed acid solution of the present invention shows a desired etching speed and exhibits excellent effects in etching process. Further, unlike conventional mixed acid solutions, the mixed acid solution of the present invention does not contains as essential components, any acids requiring a large environmental burden upon disposal thereof such as acetic acid and phosphoric acid, so that no malodor problem is caused, and burden required upon disposal of the waste solution can be lessened. In addition, in the process for producing the mixed acid solution according to the present invention, it is possible to produce a high-concentration mixed acid solution by a simple method. Furthermore, in the present invention, the waste mixed acid solution used in the etching process can be readily recycled by removing hexafluorosilicic acid therefrom, and the resultant mixed acid solution can also be used in other application fields, thereby exhibiting industrially useful effects.

## Claims

1. An etching solution containing at least hydrofluoric acid, nitric acid and hexafluorosilicic acid, the concentration of the hexafluorosilicic acid being not less than 10% by weight based on the weight of the etching solution.

2. An etching solution according to claim 1, wherein the concentration of the hexafluorosilicic acid is 15 to 40% by weight based on the weight of the etching solution.

3. An etching solution according to claim 1 or claim 2, wherein the concentration of the hydrofluoric acid is 1 to 20% by weight based on the weight of the etching solution.

4. An etching solution according to any one of claims 1 to 3, wherein the concentration of the nitric acid is 20 to 60% by weight based on the weight of the etching solution.

5. An etching solution according to any one of claims 1 to 4, further comprising acetic acid.

6. An etching solution according to claim 5, wherein the concentration of the acetic acid is 0.01 to 5% by weight based on the weight of the etching solution.

7. An etching solution according to any one of claims 1 to 6, which is used for etching a silicon substrate.

8. A process for producing an etching solution containing hydrofluoric acid, nitric acid and hexafluorosilicic acid by reacting hydrofluoric acid, nitric acid and a silicon compound with each other, comprising:

using a hydrogen fluoride gas as the hydrofluoric acid or fuming nitric acid as the nitric acid; and

reacting the hydrofluoric acid or the nitric acid with the silicon compound.

9. A process according to claim 8, wherein a hydrogen fluoride gas is used as the hydrofluoric acid, and an aqueous nitric acid solution having a concentration of not less than 70% by weight is used as the nitric acid.

10. A process for etching a silicon substrate, comprising:

subjecting a silicon substrate to etching treatment using an etching solution comprising at least hydrofluoric acid, nitric acid and hexafluorosilicic acid;

after the etching treatment, subjecting the etching solution to quantitative analysis to determine a composition of the etching solution;

controlling the concentration of the etching solution after the etching treatment on the basis of the results of the quantitative analysis such that the concentrations of hydrofluoric acid, nitric acid and hexafluorosilicic acid are 1 to 20% by weight based on the weight of the etching solution, 20 to 60% by weight based on the weight of the etching solution and not less than 10% by weight based on the weight of the etching solution, respectively; and

etching the silicon substrate using the resultant solution as an etching solution.

11. A process according to claim 10, wherein the concentration of the etching solution after the etching treatment is controlled by adding the respective components each having a concentration lower than the predetermined concentration thereto.

12. A process according to claim 10 or claim 11, wherein the concentration of the etching solution after the etching treatment is controlled by taking out a part of the etching solution, removing the hexafluorosilicic acid from the etching solution taken-out, and adding the resultant solution to the etching solution after the etching treatment.

13. A process for producing a semiconductor device, comprising:

etching silicon and/or a silicon compound film of the semiconductor device mainly constituted by a silicon substrate or a silicon thin film, with an etching solution containing hydrofluoric acid, nitric acid and hexafluorosilicic acid, the concentration of the hexafluorosilicic acid contained in the etching solution being not less than 10% by weight based on the weight of the etching solution.

# FIG.1